# EUROPEAN PATENT SPECIFICATION

(11) **EP 4 525 564 B1**
(45) Date of publication and mention of the grant of the patent: **24.12.2025**
(21) Application number: 25155819.3
(22) Date of filing: 13.01.2021
(51) Int. Cl.: G06K 19/077, H05K 1/14, H05K 3/40, H05K 1/18, H05K 3/28

(54) **SYSTEM AND METHOD FOR MANUFACTURING AND ASSEMBLING PACKAGED ELECTRONIC MODULES**
SYSTEM UND VERFAHREN ZUR HERSTELLUNG UND MONTAGE VERPACKTER ELEKTRONISCHER MODULE
SYSTÈME ET PROCÉDÉ DE FABRICATION ET D'ASSEMBLAGE DE MODULES ÉLECTRONIQUES CONDITIONNÉS

(30) Priority: 16.01.2020 US 202016745186
(43) Date of publication of application: 19.03.2025
(62) Divisional of application: 21784638.5
(73) Proprietor: Ellipse World, Inc., Culver City, CA 90232 (US)
(72) Inventor: LALO, Cyril, Los Angeles, CA, 90064 (US); POCHIC, Sebastien, 1030 Schaerbeek (BE); ESSEBAG, Jacques, 75116 Paris (FR)
(74) Representative: Germain Maureau

(56) References cited:
- JP-A- H09 199 669
- US-A1- 2016 081 193
- US-B1- 6 356 448

## Description

### Field of the Invention

This invention relates to electronic modules, including systems and methods for the manufacturing and/or assembly of electronic modules for use in smart cards.

### Background

Smart cards, chip cards or integrated circuit cards (ICCs) typically include a credit card-sized card with an embedded integrated circuit (IC) chip and other elements. Smart cards are commonly used to control access to resources such as a bank or credit card account for financial transactions, to provide personal identification, authentication, data storage, application processing and for other purposes.

Many smart cards include a pattern of metal contacts (e.g., a contact plate) to provide electrical connectivity (e.g., via a card reader) to the internal chip.

Current processes of manufacturing and/or assembling the chips, the contact plate and other elements within the card require a large number of steps, and as a result, are time consuming, expensive and prone to problems. Documents US 6 356 448, JP H09 199669 and US 2016/081193 disclose known smartcards and their respective assembling processes.

Accordingly, there is a need for a process of manufacturing and/or assembling packaged electronic modules for use within smarts cards that reduces the number of steps, the time required for the process, the expense of the process and the problems that may occur.

### Brief Description of the Drawings

Various other objects, features and attendant advantages of the present invention will become fully appreciated as the same becomes better understood when considered in conjunction with the accompanying drawings, in which like reference characters designate the same or similar parts throughout the several views, and wherein:
**FIG. 1** shows aspects of a packaged electronic module according to exemplary embodiments hereof;
**FIG. 2A** shows aspects of a contact plate according to exemplary embodiments hereof;
**FIG. 2B** shows aspects of a printed circuit according to exemplary embodiments hereof;
**FIGS. 3-9** show aspects of a packaged electronic module according to exemplary embodiments hereof;
**FIG. 10** shows aspects of a contact plate tape according to exemplary embodiments hereof;
**FIG. 11** shows aspects of a printed circuit tape according to exemplary embodiments hereof;
**FIGS. 12-13** show aspects of a packaged electronic module according to exemplary embodiments hereof; and
**FIG. 14** shows aspects of an etched contact plate configured with a packaged electronic module according to exemplary embodiments hereof.

### Detailed Description of Exemplary Embodiments

In general, and according to exemplary embodiments hereof, the invention includes systems and methods of manufacturing and/or assembling packaged electronic modules that may then be integrated into value-add smart cards (e.g., value-add credit cards, value-add debit cards, etc.).

In some embodiments, the system and method require only the use of standardized equipment and/or machinery thereby minimizing the need to develop or purchase new equipment.

In addition, the system and method may use standardized parts (e.g., ISO 7816 contact plates) and procedures such that existing certifications and/or quality labels may be leveraged for the end products (e.g., Mastercard CQM labels for ICM). Note however that other parts that may be standardized and/or non-standardized may also be used.

Accordingly, the invention provides a system and method for the manufacturing and/or assembly of all-in-one packaged electronic modules that is practical, cost-effective and scalable for industrial production.

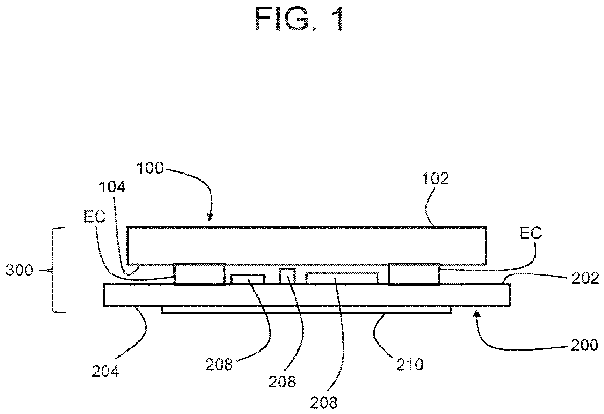

Referring now to **FIGS. 1-14****,** the invention according to exemplary embodiments hereof will be described in further detail. It is understood that the elements illustrated in the **FIGS. 1-14** may or may not be to scale or shown in actual proportion with respect to one another.

**FIG. 1** depicts a general representation of a contact plate **100** electrically configured with a printed circuit **200** to form a packaged electronic module **300.** The contact plate **100** includes a top **102** and a bottom **104,** and the printed circuit **200** includes a top **202** and a bottom **204.** In some embodiments, the printed circuit **200** includes electronic components **208** and a value-add component **210.** In some embodiments, the value-add component **210** may include a display, a fingerprint sensor, an LED device, any other type of value-add component and any combination thereof.

In some embodiments, the contact plate **100** and the printed circuit **200** are electrically connected by electrical connectors **EC.** It is understood that **FIG.** 1 is meant for demonstration and that it does not represent the number, architecture or location of the electrical connectors **EC,** nor does the figure represent the relative sizes and shapes of the contract plate **100,** the printed circuit **200** or the electrical connectors **EC.** In some embodiments, the electrical connectors **EC** include electrical elements configured with the contact plate **100,** electrical elements configured with the printed circuit **200** and/or any combination thereof.

### Two-Part Assembly #1

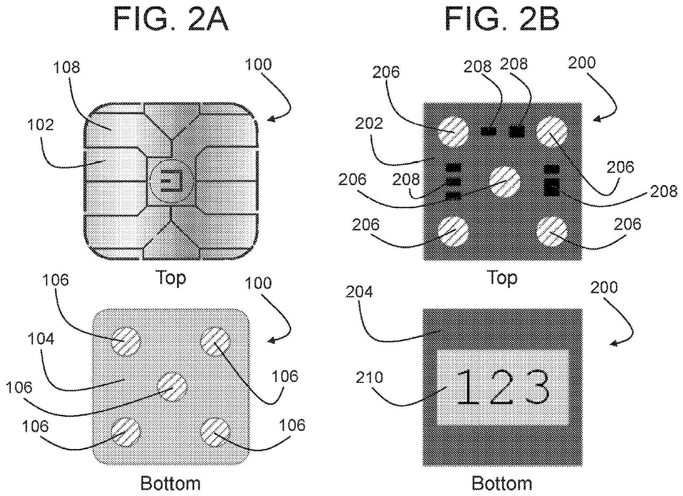

**FIG. 2A** shows the top **102** and bottom **104** of the contact plate **100.** In one exemplary embodiment hereof, the contact plate **100** includes one or more electrical connectors **106** on one surface (*e.g*., on the bottom **104** of the contact plate **100**) and one or more corresponding electrical contact points **108** on an opposite surface (*e.g.*, on the top **102** of the contact plate **100**). Each electrical connector **106** is preferably electrically tied to one or more associated contact points **108** according to the pinout of the packaged electronic module **300.**

Other types of components such as electrical components **208,** one or more antennas and/or other devices also may be configured on the underside **104** of the contact plate **100.** In some embodiments, corresponding areas on the printed circuit **200** may be readied to receive the electrical components **208** upon the electrical mating of the contact plate **100** and the printed circuit **200.** In other embodiments, devices configured on the underside **104** of the contact plate **100** may fit within the gap formed between the contact plate **100** and the printed circuit **200** when the plate **100** and circuit **200** are mated. This will be described in other sections.

In one implementation as shown, the contact plate **100** includes five electrical connectors **106.** In other embodiments, the contact plate **100** may include other numbers of electrical connectors **106.** For example, if the contact plate **100** includes an antenna or other element on its underside, the contact plate **100** may include seven electrical connectors **106** (two additional electrical connectors **106** for the antenna). Any other number of electrical connectors **106** may also be used.

In some embodiments, the contact plate **100** conforms to the specifications of an ISO 7816 contact plate. It is understood however that other types of contact plates **100** conforming to other standards may also be used and that the scope of the system **10** is not limited in any way by the type of contact plate **100** that may be used.

In some embodiments, the electrical connectors **106** are formed with the contact plate **100** during the manufacturing process of the contact plate **100.** In other embodiments, the electrical connectors **106** are attached to the contact plate **100** using surface-mount technology (SMT), using electrically conductive adhesive bonds with anisotropic conductive adhesive/film (ACF bonding), soldering, wire bonding, using other attachment techniques or any combination thereof.

**FIG. 2B** shows the top **202** and bottom **204** of the printed circuit **200.** In one exemplary embodiment hereof, the printed circuit **202** includes one or more electrical connectors **206** on one surface (e.g., on the top **202** of the printed circuit **202**) that lead to associated electrical components **208** configured with the printed circuit **200** according to the pinout of the packaged electronic module **300.** In one implementation as shown, the printed circuit **200** includes five electrical connectors **206.** It is understood however that the printed circuit **200** may include any number of electrical connectors **206.**

In some embodiments, the electrical connectors **206** are formed with the printed circuit **200** during the manufacturing process of the printed circuit **200.** In other embodiments, the electrical connectors **206** are attached to the printed circuit **200** using surface-mount technology (SMT), using electrically conductive adhesive bonds with anisotropic conductive adhesive/film (ACF bonding), soldering, wire bonding, using other attachment techniques or any combination thereof.

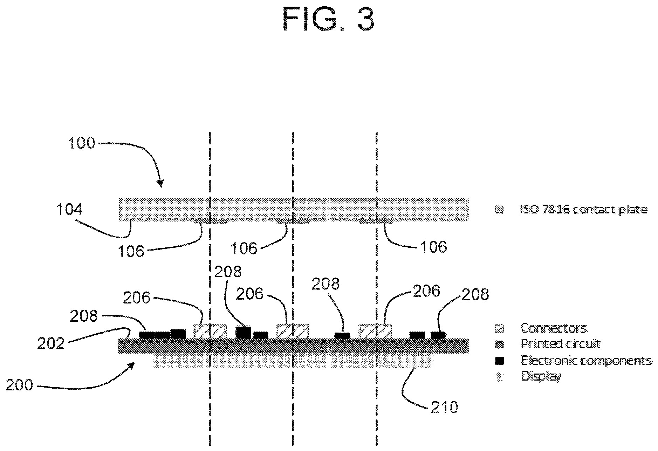

In one exemplary embodiment hereof as shown in **FIG.** 3, with the contact plate **100** in planar alignment above the printed circuit **200,** and with the contact plate's electrical connectors **106** facing the printed circuit's electrical connectors **206,** the one or more electrical connectors **106** on the contact plate **100** are in alignment with at least one of the one or more electrical connectors **206** on the printed circuit **200**. In a preferred implementation, the one or more electrical connectors **106** on the contact plate **100** are in alignment with each corresponding electrical connectors **206** on the printed circuit **200.** For example, in a preferable implementation, the contact plate's five electrical connectors **106** (best seen in **FIG. 2A**) are in alignment with the printed circuit's corresponding five electrical connectors **206** (best seen in **FIG. 2B**).

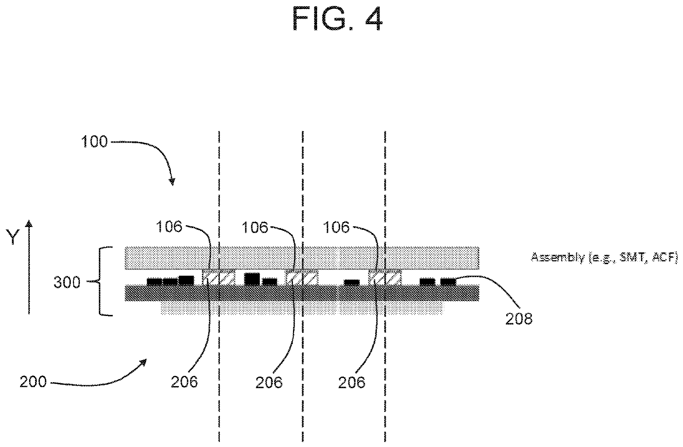

As shown in **FIG. 4****,** while in planar alignment, the contact plate **100** and the printed circuit **200** are joined such that the desired electrical connectors **106** on the contact plate **100** are electrically mated to the corresponding electrical connectors **206** on the printed circuit **200.** This assembles the contact plate **100** with the printed circuit **200** to form the packaged electronic module **300.** Conductive grease (electrical paste) may be used to mate the electrical connectors **106, 206** respectively, to reduce contact resistance, repel moisture, inhibit corrosion and prevents static buildup. Other mating techniques may also be used.

In one exemplary embodiment hereof, the electronic components **208** are not damaged or compromised in any way by the mating of the contact plate **100** with the printed circuit **200.** In one embodiment, the height of the electronic components **208** (along the Y-axis of **FIG. 4**), is less than the height of the gap between the contact plate **100** and the printed circuit **200** formed by the mating of the plate **100** and the circuit **200.** In one embodiment, the height of the combined electrical connectors **106** and **206** forms a gap between the plate **100** and the circuit **200** that safely accommodates the electronic components **208.**

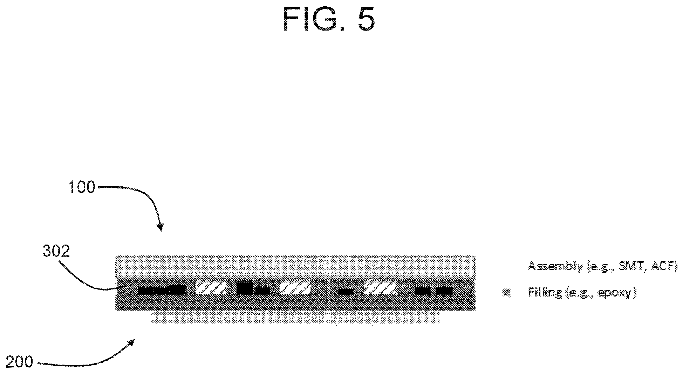

In one embodiment as shown in **FIG. 5****,** the cavity formed between the contact plate **100** and the printed circuit **200** in the assembled packaged electronic module **300** may be potted with a thermoplastic **302,** polyurethane, silicon rubber gel or other suitable potting material. This may bond the contact plate **100** with the printed circuit **200,** help prevent damage to the module **300** from shock and vibration and exclude moister and/or corrosive elements.

### Two-Part Assembly #2

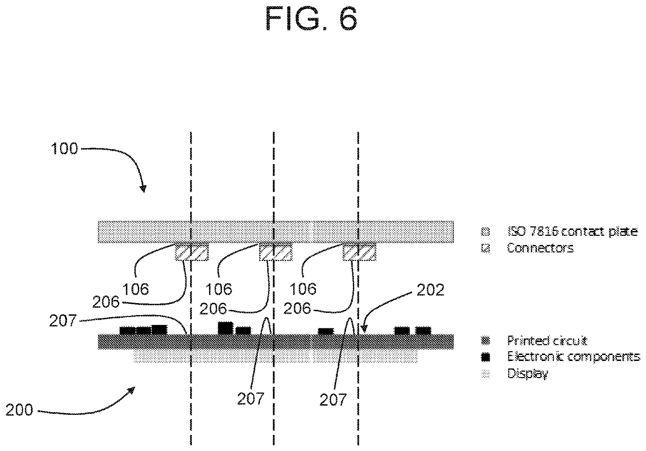

In one exemplary embodiment as shown in **FIG. 6****,** the printed circuit's electrical connectors **206** are mated with their corresponding electrical connectors **106** on the contact plate **100** prior to being configured with the printed circuit **200.** In this way, the printed circuit's electrical connectors **206** may act as extensions to the contact plate's electrical connectors **106.** In this implementation, corresponding areas **207** on the printed circuit **200** (*e.g.*, on the top **202** of the printed circuit **200**) are adapted to receive the electrical connectors **206.** The corresponding areas **207** are preferably free of obstructions and are readied for receiving the electrical connectors **206** upon the electrical mating of the contact plate **100** and the printed circuit **200.** The corresponding areas **207** may include electrical contacts that electrically mate with the electrical connectors **206** to electrically tie the electrical connectors **206** to electrical components **208** and other elements.

In one embodiment, the combined electrical connectors 106 and 206 may be replaced by a single electrical connector 106 that may include a length generally equivalent to the length of the combined electrical connectors 106, 206. In this way, the single (longer) electrical connector 106 may provide the same or similar result as the combined electrical connectors 106, 206 by extending from the underside 104 of the contact plate 100 to the corresponding areas **207** on the printed circuit **200** (*e.g*., on the top **202** of the printed circuit **200**).

Other types of components such as electrical components **208,** one or more antennas and/or other devices also may be configured on the underside **104** of the contact plate **100.** In some embodiments, corresponding areas on the printed circuit **200** may be readied to receive the electrical components **208** upon the electrical mating of the contact plate **100** and the printed circuit **200**. In other embodiments, devices configured on the underside **104** of the contact plate **100** may fit within the gap formed between the contact plate **100** and the printed circuit **200** when the plate **100** and circuit **200** are mated. This will be described in other sections.

As illustrated in **FIG. 6****,** with the contact plate **100** in planar alignment above the printed circuit **200,** and with the contact plate's electrical connectors **106** configured with the printed circuit's electrical connectors **206** facing the surface on the printed circuit **200,** the one or more combined electrical connectors **106, 206** on the contact plate **100** are preferably in alignment with at least some of the corresponding areas **207** on the printed circuit **200** readied to receive the printed circuit's electrical connectors **206.** In a preferred implementation, the one or more combined electrical connectors **106, 206** on the contact plate **100** are in alignment with each corresponding area **207** on the printed circuit **200** readied to receive the electrical connectors **206.** For example, in a preferable implementation, the five combined electrical connectors **106, 206** on the contact plate **100** (*e.g.*, in the pattern as seen in **FIG. 2A**) are in alignment with the printed circuit's corresponding five areas **207** readied to receive the printed circuit's electrical connectors **206** (in the pattern as seen in **FIG. 2B**).

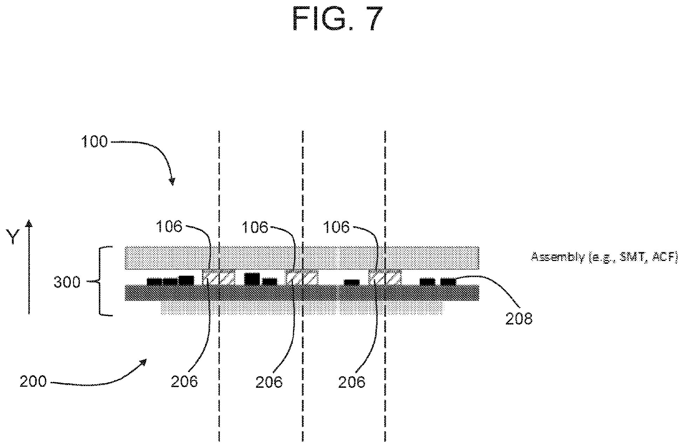

As shown in **FIG. 7****,** while in planar alignment, the contact plate **100** and the printed circuit **200** are joined and the desired combined electrical connectors **106, 206** on the contact plate **100** are electrically mated to the corresponding areas **207** on the printed circuit **200** readied to receive the electrical connectors **206.** This assembles the contact plate **100** with the printed circuit **200** to form the packaged electronic module **300.**

In some embodiments, the electrical connectors **206** are attached to the corresponding areas **207** on the printed circuit **200** ready to receive the connectors **206** using surface-mount technology (SMT), electrically conductive adhesive bonds with anisotropic conductive adhesive/film (ACF bonding), soldering, wire bonding, other attachment techniques or any combination thereof.

As with the other embodiments, the electronic components **208** are not damaged or compromised in any way by the mating of the contact plate **100** with the printed circuit **200.** In one embodiment, the height of the electronic components **208** (along the Y-axis of **FIG. 7**), is less than the height of the gap between the contact plate **100** and the printed circuit **200** formed by the mating of the plate **100** and the circuit **200.** In one embodiment, the height of the combined electrical connectors **106** and **206** forms a gap between the plate **100** and the circuit **200** that safely accommodates the electronic components **208.**

As with the other embodiments, the cavity formed between the contact plate **100** and the printed circuit **200** in the assembled packaged electronic module **300** may be potted with a thermoplastic, polyurethane, silicon rubber gel or other suitable potting material. This may bond the contact plate **100** with the printed circuit **200,** help prevent damage to the module **300** from shock and vibration and exclude moister and/or corrosive elements.

### N-Part Assembly

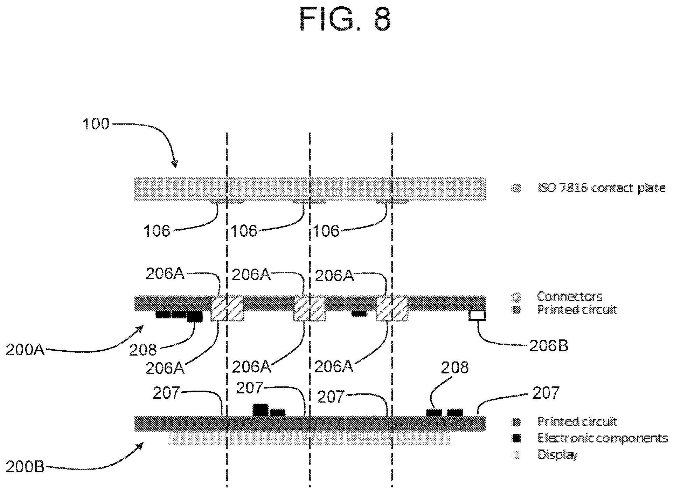

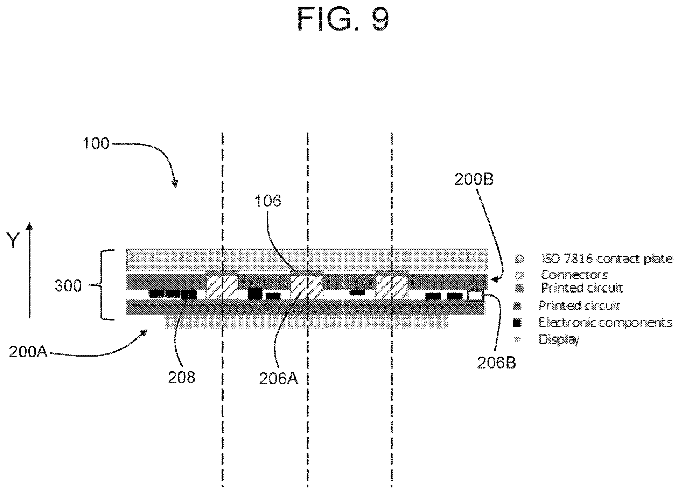

As shown in **FIG. 8****,** packaged electronic module **300** includes two or more printed circuits **200A, 200B,** ... **200N** that when combined form the overall printed circuit **200,** and a contact plate **100.** For example, the mating of the contact plate **100** with printed circuit **200A** and printed circuit **200B of** **FIG. 8** may form the packaged electronic module **300 of** **FIG. 9****.** While **FIG. 8** depicts electronic components **208** generally configured on the bottom surface of printed circuit **200A** and on the top surface of printed circuit **200B,** it is understood that electrical components **208** also may be configured on the upper surface of printed circuit **200A,** on the lower surface of printed circuit **200B** and/or on any other surface of printed circuit **200A** and/or on any surface of printed circuit **200B.**

In one embodiment, the printed circuit **200** configured directly beneath the contact plate **200** (*e.g.*, printed circuit **200A)** includes electrical connectors **206A** that are aligned with at least some of the contact plate's electrical connectors **106.** In this way, when the contact plate **100** is configured with the printed circuit **200A,** the circuit board's electrical connectors **206A** may electrically mate with the aligned electrical connectors **106** on the contact plate **200.**

In some embodiments, at least some of the electrical connectors **206A** on the top of the printed circuit **200A** pass through the printed circuit **200A** and are accessible to the lower printed circuit board **200** (*e.g.*, **200B).** In some embodiments, the top of the lower printed circuit **200B** includes corresponding areas **207** adapted to receive the electrical connectors **206A** that pass through the printed circuit **200A.** The corresponding areas **207** are preferably free of obstructions and are readied for receiving the electrical connectors **206A** upon the electrical mating of the upper printed circuit **200A** and the lower printed circuit **200B.** The corresponding areas **207** may include electrical contacts that electrically mate with the electrical connectors **206A** to electrically tie the electrical connectors **206A** to electrical components **208** and other elements.

In some embodiments, the upper printed circuit **200A** includes electrical connectors **206B** that do not pass through the printed circuit **200A** but that are configured with the lower surface of the printed circuit **200A** and that are adapted to mate with corresponding areas **207** on the lower printed circuit **200B** when the printed circuits **200A** and **200B** are electrically mated. The corresponding areas **207** may include electrical contacts that electrically mate with the electrical connectors **206B** to electrically tie the electrical connectors **206B** to electrical components **208** and other elements.

It is understood that the electrical connectors **200A** and **200B** may be adapted to electrically connect one or more electrical components **208** (configured with printed circuits **200A** and/or **200B**) with the contact plate **100.**

As with the other embodiments, the electronic components **208** (included on printed circuit **200A** and/or **200B**) are not damaged or compromised in any way by the mating of the printed circuits **200A** and **200B** to form the printed circuit **200,** or by the mating of the printed circuits **200, 200A** and/or **200B** with the contact plate **100.** In one embodiment, the height of the electronic components **208** (along the Y-axis of **FIG.** 9), is less than the height of the gap in which the components **208** may reside. For example, the height of the electronic components **208** configured within the gap between the printed circuit **200A** and printed circuit **200B** may be less than the gap between the printed circuits **200A** and **200B.** In one embodiment, the height of the electrical connectors **206** between the circuits **200A** and **200B** forms a gap between the circuits **200A, 200B** that safely accommodates the electronic components **208.**

In another example, the height of any electronic components **208** configured within the gap between the printed circuit **200A** and the contact plate **100** may be less than the gap between the printed circuit **200A** and the contact plate **100.** In one embodiment, the height of the combined electrical connectors **106** (on the lower surface of the contact plate **100** and electrical connectors **206** (on the upper surface of the printed circuit **200A**) forms a gap between the plate **100** and the circuit **200A** that safely accommodates the electronic components **208.**

As with the other embodiments, the cavity formed between the contact plate **100** and the printed circuit **200A** and the cavity formed between circuits **200A** and **200B** in the assembled packaged electronic module **300** may be potted with a thermoplastic, polyurethane, silicon rubber gel or other suitable potting material. This may bond the contact plate **100** with the printed circuit **200A** and the printed circuit **200A** with printed circuit **200B,** help prevent damage to the module **300** from shock and vibration and exclude moister and/or corrosive elements.

It is understood that while the example described above with respect to **FIGS. 8** and **9** depicts two printed circuits **200A** and **200B** configured with a contact plate **100** to form the packaged electronic module **300,** any number of printed circuits **200N** may be combined with the contact plate **100** to form the packaged electronic module **300.** It is also understood that the details described above with respect to printed circuits **200A** and **200B** also may pertain to any other printed circuits **200N** that may be configured with the printed circuits **200A** and **200B** to form an overall printed circuit **200** and/or the packaged electronic module **300.** It is also understood that the scope of the system **10** is not limited in any way by the number of printed circuits **200N** that may be configured with a contact plate **100** to form a packaged electronic module **300.**

### Forming the Contact Plates and/or the Printed Circuits

In one exemplary embodiment hereof, the contact plate **100** and the printed circuit **200** (whether a single printed circuit **200** or a printed circuit **200** comprising two or more printed circuits **200N**) are each formed individually and then combined as described above to form a packaged electronic module **300.**

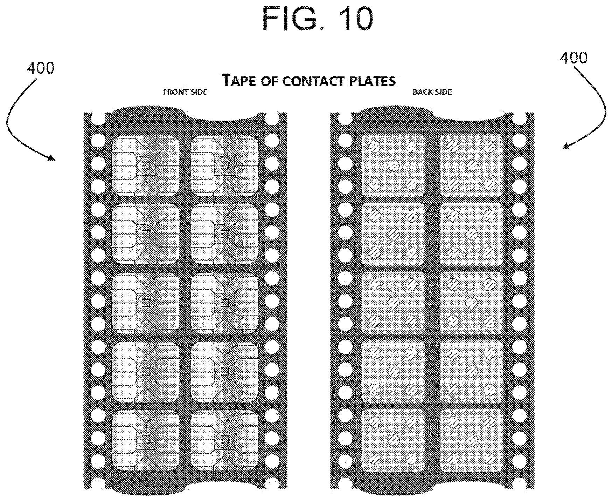

In one exemplary embodiment hereof as shown in **FIG. 10****,** each contact plate **100** is formed as part of a tape **400** that contains a plurality of parts. In some embodiments, the plurality of parts may be identical (e.g., identical contact plates **100**), while in other embodiments the parts may be different or any combination thereof.

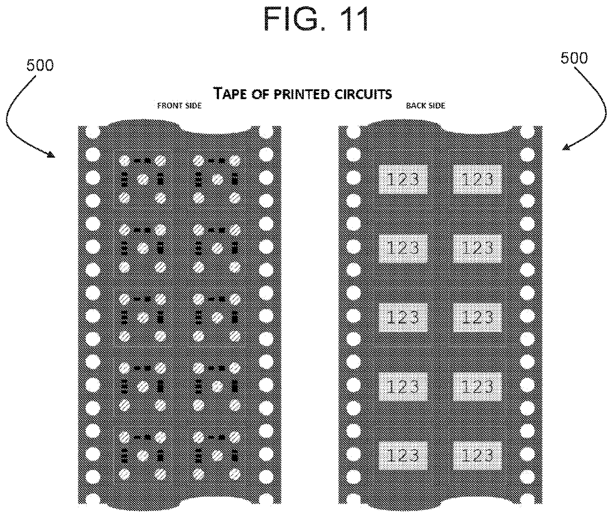

In one exemplary embodiment hereof as shown in **FIG. 11****,** each printed circuit **200** is formed as part of a tape **500** that contains a plurality of parts. In some embodiments, the plurality of parts may be identical (e.g., identical printed circuits **200**), while in other embodiments the parts may be different or any combination thereof.

While **FIG. 10** illustrates a tape **400** including two side-by-side rows of contact plates **100,** and **FIG. 11** illustrates a tape **500** including two side-by-side rows of printed circuits **200,** it is understood that the tape **400** may include any number of contact plates **100** in any formation, and that the tape **500** may include any number of printed circuits **200** in any formation. It may be preferable that the number and formation of contact plates **100** included in the tape **400** generally match the number and formation of printed circuits **200** included in the tape **500,** but this may not be necessary.

In one exemplary embodiment hereof, the tape **400** of contact plates **100** may be diced to extract each individual contact plate **100** from the tape **400.** In one exemplary embodiment hereof, the tape **500** of printed circuits **200** may be diced to extract each individual printed circuit **200** from the tape **500.** In some embodiments, the tapes **400, 500** may each include weakened die cut lines defining the perimeter of the contact plate **100** and the printed circuit **200,** respectively, that may facilitate breaking of the tapes **400, 500** along the weakened die cut lines to extract each component **100, 200.** In other embodiments, a die cut tool or any other type of tool or process may be used to extract the individual components from the tapes **400** and **500.**

Once the contact plates **100** and the printed circuits **200** are extracted from the tapes **400, 500** respectively, the plates **100** and the circuits **200** may be configured as described in other sections. It is understood that any number of printed circuits **200N** may be formed on and extracted from any number of tapes **500N** and subsequently combined with the contact plates **100** as described.

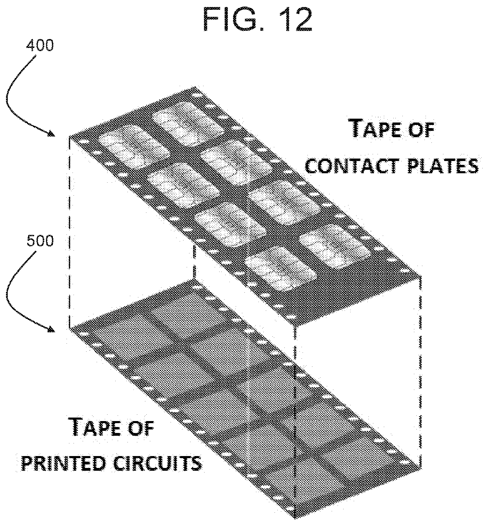

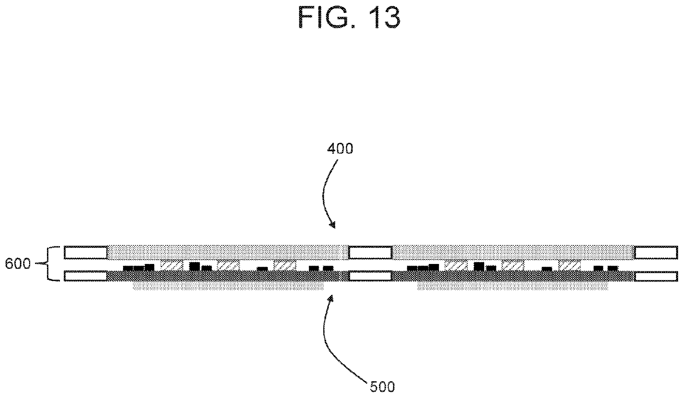

In one exemplary embodiment hereof as shown in **FIGS. 12** and **13****,** the tape **400** of contact plates **100** is aligned and electrically mated with the tape **500** of printed circuits **200** to form the combined tape **600** of packaged electronic modules **300.** This may be referred to as assembling the components **100, 200** roll-to-roll.

In one exemplary embodiment hereof, the details described in other sections with regards to the mating of an individual contact plate **100** with an individual printed circuit **200** (whether a single printed circuit **200** or a printed circuit **200** comprising two or more printed circuits **200N**) to form an individual packaged electronic module **300** also pertain to this embodiment with regards to the mating of a plurality of contact plates **100** (as part of a tape **400**) with a plurality of printed circuits **200** (as part of a tape **500**) to form a tape **600** of corresponding pluralities of packaged electronic modules **300.**

It is also understood that while the example described above with reference to **FIGS. 10-13** depict the combining of two tapes (tape **400** of contact plates **100** with tape **500** of printed circuits **200**) to form a combined tape **600** of packaged electronic modules **300,** any number of tapes may be combined to form a combined tape of packaged electronic modules **300.** For example, a tape **400** of contact plates **100** may be combined with a first printed circuit tape **500-1** and a second printed circuit tape **500-**2 to form a combined tape **600** of packaged electronic modules **300.** It is understood that a tape **400** of contact plates **100** may be combined with any number of printed circuit tapes **500-N** to form a tape **600** of packaged electronic modules **300.**

In one exemplary embodiment hereof, the resulting tape **600** of packaged electronic modules **300** may be diced to extract each individual packaged electronic module **300** from the tape **600.** In some embodiments, the tapes **400, 500** and **600** may each include weakened die cut lines defining the perimeter of the packaged electronic modules **300** that may facilitate breaking of the combined tape **600** along the weakened die cut lines to extract each module **300.** In other embodiments, a die cut tool or any other type of tool or process may be used to extract the individual packaged electronic modules **300** from the tape **600.**

In one exemplary embodiment hereof, the tapes **400** and **500** include industry standard 35mm width tape. However, it is understood that any type of tapes **400, 500** of any widths may be used.

### Etched Contact Plate

In one exemplary embodiment hereof, the contact plate **100** is etched onto one surface of the printed circuit **200.** In one embodiment, the etching of the contact plate **100** onto the printed circuit **200** may be performed during the manufacturing process of the printed circuit **200.**

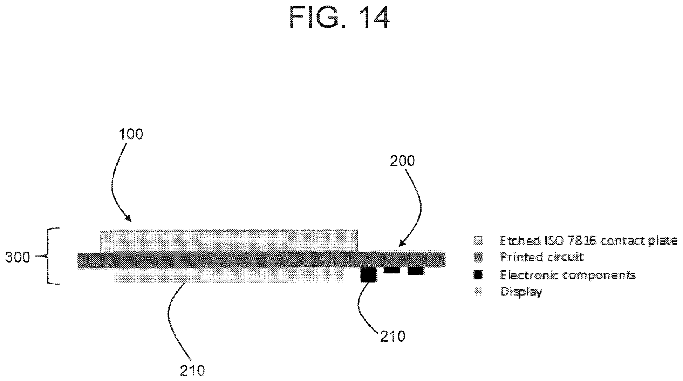

In one embodiment, a mask may be applied to the circuit laminate to protect the copper (or other metal) in the area of the desired contact plate. Then, during the etching process, the mask may generally facilitate the formation of the contact plate. Once the contact plate is formed, the mask may be removed. The resulting contact plate **100** etched onto the (upper) surface of the printed circuit **200** is shown in **FIG. 14****.** Note that the contact plate **100** also may be etched into the lower surface of the printed circuit **200,** and onto any surface of any circuit board **200N.**

### Additional Information

In any of the embodiments herein, the printed circuit **200** may include any type of substrate, including but not limited to, PI (polyimide), FR-4 (fiberglass), any other type of substrate and any combination thereof.

In any of the embodiments herein, the attachment and/or connection of the electronical connectors **106** to the electrical connectors **206** may include using SMT, ACF, soldering, wire bonding, any other applicable technology and any combination thereof.

In any of the embodiments herein, the attachment and/or connection of the electrical connectors **106** and/or the electrical connectors **206** to the corresponding areas **207** adapted to receive the electrical connectors **106, 206** on the printed circuit may include using SMT, ACF, soldering, wire bonding, any other applicable technology and any combination thereof.

In any of the embodiments herein, the attachment and/or connection of the electronic components **208** to the printed circuits **200, 200A, 200B,** ... **200N** may include using SMT, ACF, soldering, wire bonding, any other applicable technology and any combination thereof.

In any of the embodiments herein, the physical footprint (size and shape) of the printed circuit **200** may be smaller than, substantially the same as, larger than or in any proportion to that of the contact plate **100.**

In any of the embodiments herein, the contact plate 100 may include a 6-pin design, an 8-pin and/or any other number of pin (n-pin) design.

In any of the embodiments herein, the value-add component **210** of the resulting packaged electronic module **300** may be on the same side of the packaged electronic module **300** as the contact plate **100,** on the opposite side of the packaged electronic module **300** as the contact plate **100,** or on any other side of the package electronic module **300.**

In any of the embodiments herein, the printed circuit **200, 200A, 200B,** ... **200N** may include an antenna and/or electronic connectors in electrical communication with an antenna embedded in the smart card body.

It is understood that any details, components, elements and/or aspects described with respect to any one of embodiments herein may also apply to any other of the embodiments described herein.

Those of ordinary skill in the art will appreciate and understand, upon reading this description, that embodiments hereof may provide different and/or other advantages, and that not all embodiments or implementations need have all advantages.

Where a process is described herein, those of ordinary skill in the art will appreciate that the process may operate without any user intervention. In another embodiment, the process includes some human intervention (*e.g*., a step is performed by or with the assistance of a human).

As used herein, including in the claims, the phrase "at least some" means "one or more," and includes the case of only one. Thus, *e.g*., the phrase "at least some ABCs" means "one or more ABCs", and includes the case of only one ABC.

As used herein, including in the claims, term "at least one" should be understood as meaning "one or more", and therefore includes both embodiments that include one or multiple components. Furthermore, dependent claims that refer to independent claims that describe features with "at least one" have the same meaning, both when the feature is referred to as "the" and "the at least one".

As used in this description, the term "portion" means some or all. So, for example, "A portion of X" may include some of "X" or all of "X". In the context of a conversation, the term "portion" means some or all of the conversation.

As used herein, including in the claims, the phrase "using" means "using at least," and is not exclusive. Thus, *e.g*., the phrase "using X" means "using at least X." Unless specifically stated by use of the word "only", the phrase "using X" does not mean "using only X."

As used herein, including in the claims, the phrase "based on" means "based in part on" or "based, at least in part, on," and is not exclusive. Thus, *e.g.*, the phrase "based on factor X" means "based in part on factor X" or "based, at least in part, on factor X." Unless specifically stated by use of the word "only", the phrase "based on X" does not mean "based only on X."

In general, as used herein, including in the claims, unless the word "only" is specifically used in a phrase, it should not be read into that phrase.

As used herein, including in the claims, the phrase "distinct" means "at least partially distinct." Unless specifically stated, distinct does not mean fully distinct. Thus, *e.g.*, the phrase, "X is distinct from Y" means that "X is at least partially distinct from Y," and does not mean that "X is fully distinct from Y." Thus, as used herein, including in the claims, the phrase "X is distinct from Y" means that X differs from Y in at least some way.

It should be appreciated that the words "first," "second," and so on, in the description and claims, are used to distinguish or identify, and not to show a serial or numerical limitation. Similarly, letter labels (*e.g*., "(A)", "(B)", "(C)", and so on, or "(a)", "(b)", and so on) and/or numbers (*e.g*., "(i)", "(ii)", and so on) are used to assist in readability and to help distinguish and / or identify, and are not intended to be otherwise limiting or to impose or imply any serial or numerical limitations or orderings. Similarly, words such as "particular," "specific," "certain," and "given," in the description and claims, if used, are to distinguish or identify, and are not intended to be otherwise limiting.

As used herein, including in the claims, the terms "multiple" and "plurality" mean "two or more," and include the case of "two." Thus, e.g., the phrase "multiple ABCs," means "two or more ABCs," and includes "two ABCs." Similarly, e.g., the phrase "multiple PQRs," means "two or more PQRs," and includes "two PQRs."

The present invention also covers the exact terms, features, values and ranges, etc. in case these terms, features, values and ranges etc. are used in conjunction with terms such as about, around, generally, substantially, essentially, at least etc. (i.e., "about 3" or "approximately 3" shall also cover exactly 3 or "substantially constant" shall also cover exactly constant).

As used herein, including in the claims, singular forms of terms are to be construed as also including the plural form and vice versa, unless the context indicates otherwise. Thus, it should be noted that as used herein, the singular forms "a," "an," and "the" include plural references unless the context clearly dictates otherwise.

Throughout the description and claims, the terms "comprise", "including", "having", and "contain" and their variations should be understood as meaning "including but not limited to", and are not intended to exclude other components unless specifically so stated.

It will be appreciated that variations to the embodiments of the invention can be made while still falling within the scope of the invention which is defined by the appended claims:
Use of exemplary language, such as "for instance", "such as", "for example" ("*e.g.*,") and the like, is merely intended to better illustrate the invention and does not indicate a limitation on the scope of the invention unless specifically so claimed.

## Claims

1. A method of assembling a packaged electronic module (300) for use with a smart card, the method comprising the steps:
(A) providing a first contact plate (100) including a first electrical connector (106), the first electrical connector (106) being configured with a first surface (104) of the first contact plate;
(B) providing a first printed circuit (200A) including a second electrical connector (206A) configured with a first surface of the first printed circuit, and a third electrical connector (206A, 206B) configured with a second surface of the printed circuit;
(C) providing a second printed circuit (200B) including a first contact area (207) configured with a first surface of the second printed circuit (200B);
(D) electrically mating the first electrical connector (106) with the second electrical connector (206A) and the third electrical connector (206A, 206B) with the first contact area (207) to form a packaged electronic module (300).

2. The method of claim 1 wherein the first surface of the first contact plate (100) includes the bottom of the first contact plate (100), the first surface of the first printed circuit (200A) includes the top of the first printed circuit, the second surface of the first printed circuit (200A) includes the bottom of the first printed circuit (200A), and the first surface of the second printed circuit (200B) includes the top of the second printed circuit (200B).

3. The method of claim 1 wherein the second electrical connector (206A) is electrically connected to the third electrical connector (206A, 206B).

4. The method of claim 1 wherein the first printed circuit (200A) includes one or more first electronic components (208), and the first electrical connector (206A) of the first printed circuit (200A) is electrically connected to at least one of the one or more first electronic components (208).

5. The method of claim 1 wherein the first contact plate (100) and/or the first printed circuit (200A) and/or the second printed circuit (200B) is configured with an antenna (166).

6. The method of claim 4 wherein the electrical mating of the first electrical connector (106) with the second electrical connector (206A) in (D) forms a first gap between the first surface of the first contact plate (100) and the first surface of the first printed circuit (200A), and wherein at least one of the one or more first electronic components (208) fits within the first gap.

7. The method of claim 1 wherein the second printed circuit (200B) includes one or more second electronic components (208), and the first contact area of the second printed circuit (200B) is electrically connected to at least one of the one or more second electronic components (208).

8. The method of claim 7 wherein the electrical mating of the third electrical connector (206A, 206B) with the first contact area in (D) forms a second gap between the second surface of the first printed circuit (200A) and the first surface of the second printed circuit (200B), and wherein at least one of the one or more second electronic components (208) fits within the second gap.

9. The method of claim 1 wherein the second printed circuit (200B) includes one or more value add components selected from the group: a display, a fingerprint sensor, and an LED device.

10. The method of claim 1 wherein the first contact area (207) includes a fourth electrical connector.

11. The method of assembling packaged electronic modules (300) according to anyone of claims 1 to 10, comprising: combining a tape (400) comprising a plurality of contact plates (100) with a tape (500) comprising a plurality of printed circuits (200A, 200B) to form a combined tape (600) of corresponding pluralities of packaged electronic modules (300).

12. The method of assembling packaged electronic modules (300) according to anyone of claims 1 to 10, comprising: combining a tape (400) of contact plates (100) with a first printed circuit tape (500-1) and a second printed circuit tape (500-2) to form a combined tape (600) of packaged electronic modules (300).

## Patentansprüche

1. Verfahren zum Zusammenbau eines verpackten elektronischen Moduls (300) zur Verwendung mit einer Smartcard, wobei das Verfahren folgende Schritte umfasst:
(A) Bereitstellen einer ersten Kontaktplatte (100), die einen ersten elektrischen Steckverbinder (106) enthält, wobei der erste elektrische Steckverbinder (106) mit einer ersten Oberfläche (104) der ersten Kontaktplatte konfiguriert ist;
(B) Bereitstellen einer ersten Leiterplatte (200A), die einen zweiten elektrischen Steckverbinder (206A), der mit einer ersten Oberfläche der ersten Leiterplatte konfiguriert ist, sowie einen dritten elektrischen Steckverbinder (206A, 206B) enthält, der mit einer zweiten Oberfläche der Leiterplatte konfiguriert ist;
(C) Bereitstellen einer zweiten Leiterplatte (200B), die einen ersten Kontaktbereich (207) enthält, der mit einer ersten Oberfläche der zweiten Leiterplatte (200B) konfiguriert ist;
(D) elektrisches Verbinden des ersten elektrischen Steckverbinders (106) mit dem zweiten elektrischen Steckverbinder (206A) und des dritten elektrischen Steckverbinders (206A, 206B) mit dem ersten Kontaktbereich (207), um ein verpacktes elektronisches Modul (300) zu bilden.

2. Verfahren nach Anspruch 1, wobei die erste Oberfläche der ersten Kontaktplatte (100) die Unterseite der ersten Kontaktplatte (100) enthält, die erste Oberfläche der ersten Leiterplatte (200A) die Oberseite der ersten Leiterplatte enthält, die zweite Oberfläche der ersten Leiterplatte (200A) die Unterseite der ersten Leiterplatte (200A) enthält und die erste Oberfläche der zweiten Leiterplatte (200B) die Oberseite der zweiten Leiterplatte (200B) enthält.

3. Verfahren nach Anspruch 1, wobei der zweite elektrische Steckverbinder (206A) elektrisch mit dem dritten elektrischen Steckverbinder (206A, 206B) verbunden ist.

4. Verfahren nach Anspruch 1, wobei die erste Leiterplatte (200) eine oder mehrere erste elektronische Komponenten (208) enthält und der erste elektrische Steckverbinder (206A) der ersten Leiterplatte (200A) elektrisch mit mindestens einer der einen oder mehreren ersten elektronischen Komponenten (208) verbunden ist.

5. Verfahren nach Anspruch 1, wobei die erste Kontaktplatte (100) und/oder die erste Leiterplatte (200A) und/oder die zweite Leiterplatte (200B) mit einer Antenne (166) konfiguriert ist.

6. Verfahren nach Anspruch 4, wobei das elektrische Verbinden des ersten elektrischen Steckverbinders (106) mit dem zweiten elektrischen Steckverbinder (206A) in (D) einen ersten Spalt zwischen der ersten Oberfläche der ersten Kontaktplatte (100) und der ersten Oberfläche der ersten Leiterplatte (200A) bildet, und wobei mindestens eine der einen oder mehreren ersten elektronischen Komponenten (208) in den ersten Spalt passt.

7. Verfahren nach Anspruch 1, wobei die zweite Leiterplatte (200B) eine oder mehrere zweite elektronische Komponenten (208) enthält und der erste Kontaktbereich der zweiten Leiterplatte (200B) elektrisch mit mindestens einer der einen oder mehreren zweiten elektronischen Komponenten (208) verbunden ist.

8. Verfahren nach Anspruch 7, wobei das elektrische Verbinden des dritten elektrischen Steckverbinders (206A, 206B) mit dem ersten Kontaktbereich in (D) einen zweiten Spalt zwischen der zweiten Oberfläche der ersten Leiterplatte (200A) und der ersten Oberfläche der zweiten Leiterplatte (200B) bildet, und wobei mindestens eine der einen oder mehreren zweiten elektronischen Komponenten (208) in den zweiten Spalt passt.

9. Verfahren nach Anspruch 1, wobei die zweite Leiterplatte (200B) eine oder mehrere Mehrwertkomponenten enthält, ausgewählt aus der folgenden Gruppe: ein Display, ein Fingerabdrucksensor und eine LED-Vorrichtung.

10. Verfahren nach Anspruch 1, wobei der erste Kontaktbereich (207) einen vierten elektrischen Steckverbinder enthält.

11. Verfahren zum Zusammenbau von verpackten elektronischen Modulen (300) nach einem der Ansprüche 1 bis 10, das Folgendes umfasst: Kombinieren eines Bandes (400), das eine Vielzahl von Kontaktplatten (100) mit einem Band (500) umfasst, das eine Vielzahl von Leiterplatten (200A, 200B) umfasst, um ein kombiniertes Band (600) aus entsprechenden Vielzahlen von verpackten elektronischen Modulen (300) zu bilden.

12. Verfahren zum Zusammenbau von verpackten elektronischen Modulen (300) nach einem der Ansprüche 1 bis 10, das Folgendes umfasst: Kombinieren eines Bandes (400) von Kontaktplatten (100) mit einem ersten Leiterplattenband (500-1) und einem zweiten Leiterplattenband (500-2), um ein kombiniertes Band (600) aus verpackten elektronischen Modulen (300) zu bilden.

## Revendications

1. Procédé d'assemblage d'un module électronique préassemblé (300) destiné à être utilisé avec une carte à puce, le procédé comprenant les étapes suivantes :
(A) la fourniture d'une première plaque de contact (100) comprenant un premier connecteur électrique (106), le premier connecteur électrique (106) étant configuré avec une première surface (104) de la première plaque de contact ;
(B) la fourniture d'un premier circuit imprimé (200A) comprenant un deuxième connecteur électrique (206A) configuré avec une première surface du premier circuit imprimé, et un troisième connecteur électrique (206A, 206B) configuré avec une seconde surface du circuit imprimé ;
(C) la fourniture d'un second circuit imprimé (200B) comprenant une première zone de contact (207) configurée avec une première surface du second circuit imprimé (200B) ;
(D) l'accouplement électrique du premier connecteur électrique (106) avec le deuxième connecteur électrique (206A) et du troisième connecteur électrique (206A, 206B) avec la première zone de contact (207) pour former un module électronique préassemblé (300).

2. Procédé de la revendication 1, dans lequel la première surface de la première plaque de contact (100) comprend le dessous de la première plaque de contact (100), la première surface du premier circuit imprimé (200A) comprend le dessus du premier circuit imprimé, la seconde surface du premier circuit imprimé (200A) comprend le dessous du premier circuit imprimé (200A), et la première surface du second circuit imprimé (200B) comprend le dessus du second circuit imprimé (200B).

3. Procédé de la revendication 1, dans lequel le deuxième connecteur électrique (206A) est connecté électriquement au troisième connecteur électrique (206A, 206B).

4. Procédé de la revendication 1, dans lequel le premier circuit imprimé (200A) comprend un ou plusieurs premiers composants électroniques (208), et le premier connecteur électrique (206A) du premier circuit imprimé (200A) est connecté électriquement à au moins un du ou des plusieurs premiers composants électroniques (208).

5. Procédé de la revendication 1, dans lequel la première plaque de contact (100) et/ou le premier circuit imprimé (200A) et/ou le second circuit imprimé (200B) est/sont configuré(e)(s) avec une antenne (166).

6. Procédé de la revendication 4, dans lequel l'accouplement électrique du premier connecteur électrique (106) avec le deuxième connecteur électrique (206A) au point (D) forme un premier espace entre la première surface de la première plaque de contact (100) et la première surface du premier circuit imprimé (200A), et dans lequel au moins un du ou des plusieurs premiers composants électroniques (208) s'insère dans le premier espace.

7. Procédé de la revendication 1, dans lequel le second circuit imprimé (200B) comprend un ou plusieurs seconds composants électroniques (208), et la première zone de contact du second circuit imprimé (200B) est connectée électriquement à au moins un du ou des plusieurs seconds composants électroniques (208).

8. Procédé de la revendication 7, dans lequel l'accouplement électrique du troisième connecteur électrique (206A, 206B) avec la première zone de contact au point (D) forme un second espace entre la seconde surface du premier circuit imprimé (200A) et la première surface du second circuit imprimé (200B), et dans lequel au moins un du ou des plusieurs seconds composants électroniques (208) s'insère dans le second espace.

9. Procédé de la revendication 1, dans lequel le second circuit imprimé (200B) comprend un ou plusieurs composants à valeur ajoutée choisis dans le groupe constitué par : un écran, un capteur d'empreintes digitales et un dispositif LED.

10. Procédé de la revendication 1, dans lequel la première zone de contact (207) comprend un quatrième connecteur électrique.

11. Procédé d'assemblage de modules électroniques préassemblés (300) selon l'une quelconque des revendications 1 à 10, comprenant : la combinaison d'une bande (400) comprenant une pluralité de plaques de contact (100) avec une bande (500) comprenant une pluralité de circuits imprimés (200A, 200B) pour former une bande combinée (600) de pluralités correspondantes de modules électroniques préassemblés (300).

12. Procédé d'assemblage de modules électroniques préassemblés (300) selon l'une quelconque des revendications 1 à 10, comprenant : la combinaison d'une bande (400) de plaques de contact (100) avec une première bande de circuit imprimé (500-1) et une seconde bande de circuit imprimé (500-2) pour former une bande combinée (600) de modules électroniques préassemblés (300).
